# EUROPEAN PATENT APPLICATION

(11) **EP 2 607 327 A1**
(43) Date of publication of application: **26.06.2013**
(21) Application number: 12008393.6
(22) Date of filing: 17.12.2012
(51) Int. Cl.: C03C 8/02, C03C 8/04, C03C 8/08, C03C 8/18, C03C 8/22, C03C 8/16

(54) **Thick-film composition containing antimony oxides and their use in the manufacture of semi-conductor devices**

(30) Priority: 23.12.2011 EP 11010193; 23.12.2011 US 201161579818 P
(71) Applicant: Heraeus Precious Metals GmbH & Co. KG, 63450 Hanau (DE)
(72) Inventor: Hörteis, Matthias, 63454 Hanau (DE); Neidert, Michael, 63179 Obertshausen (DE)
(74) Representative: Herzog, Martin

(57) **Abstract**

This invention provides a thick-film composition for printing the front-side of a solar cell device having one or more insulating layers. The composition comprises a bismuth oxide comprising glass frit and antimony oxide as part of the glass frit or an additive. The invention further refers to a process for preparing a semiconductor device by use of the thick-film composition and an article, especially a solar cell comprising the semiconductor device. The solar cells show improved efficiency.

## Description

### FIELD OF THE INVENTION

This invention provides a thick-film composition for the use in semiconductor devices. In particular it provides a thick film composition for printing the front-side of a solar cell device having one or more insulating layers. The invention further refers to a process for preparing a semiconductor device, and an article comprising the semiconductor device.

### TECHNICAL BACKGROUND

The present invention can be applied to a broad range of semiconductor devices, although it is especially effective in light-receiving elements such as photodiodes and solar cells. In the following the background of the invention is described with reference to solar cells as a specific example of the prior art.

Most common solar cells are those based on silicon, more particularly, a p-n junction made from silicon by applying an n-type diffusion on a p-type silicon substrate, or a p-type diffusion on an n-type silicon substrate, coupled with two electrical contact layers or electrodes. The diffused layer, called emitter forms the pn-junction. In order to minimize reflection of the sunlight by the solar cell, an antireflection coating, such as silicon nitride, is applied to the emitter. Using a conductive composition, e.g. a silver paste a grid-like metal contact may be screen printed onto the antireflection layer to serve as a front electrode. This electrical contact layer on the face or front of the cell, where light enters, is typically present in a grid pattern made of "finger lines" and "bus bars". Finally, a rear contact is applied to the substrate, such as by applying a backside silver or silver/aluminum paste followed by an aluminum paste to the entire backside of the substrate. The device is then fired at a high temperature to convert the metal pastes to metal electrodes. A description of a typical solar cell and the fabrication method thereof may be found, for example, in Handbook of photovoltaic science and engineering, edited by A. Luque and S. Hegedus, John Wiley & Sons, Ltd., 2nd ed. 2011 or Peter Würfel, Physiks of Solar Cells, Wiley VCH Verlag GmbH & Co. KGaA, Weinheim, 2nd ed. 2009.

Conductive compositions used to form the conductive grids or metal contacts typically include a glass frit, a conductive species (e.g., silver particles), and an organic medium.

The anti-reflective coating, such as silicon nitride, silicon oxide, titanium oxide, or aluminum oxide also acts as an insulating passivation layer, which impairs the flow of electrons from the substrate to the metal contacts. To overcome this problem, the conductive composition must penetrate the anti-reflective coating during firing to form metal contacts having electrical contact with the semiconductor substrate. Formation of a strong bond between the metal contact and the substrate is also desirable.

Up to now high efficiency composition contain glass frits comprising lead oxide the use of which should be avoided for ecological reasons.

Thus, there is a need of providing an economical process for manufacturing photovoltaic (PV) cells with good efficiency made by using thick-film compositions that are lead-free or nearly lead-free and upon firing penetrate an anti-reflective coating and provide good electrical contact with the semiconductor substrate.

### SUMMARY

One aspect of the present invention is a thick-film composition comprising:
a) a metal or derivative thereof;
b) a bismuth oxide containing glass frit;
c) optionally additives; and
d) an organic medium,
wherein the composition comprises antimony oxide.

Another aspect of the present invention is a process including:
(i) providing a semiconductor substrate including one or more insulating films deposited thereon;
(ii) applying a thick-film composition comprising a metal or derivative thereof, a bismuth oxide containing glass frit, optionally additives; an organic medium, and antimony oxide onto the one or more insulating films to form a layered structure; and
(iii) firing the semiconductor substrate, one or more insulating films, and thick-film composition, forming an electrode in contact with the one or more insulating layers and in electrical contact with the semiconductor substrate.

Another aspect of this invention is an article including:
a) a semiconductor substrate;
b) one or more insulating layers on the semiconductor substrate; and
c) an electrode in contact with the one or more insulating layers and in electrical contact with the semiconductor substrate, the electrode comprising bismuth oxide and an electrically conductive metal and antimony-oxide.

The thick film conductive composition according to the invention comprises four essential components: metal, bismuth oxide, antimony oxide, and an organic medium. The thick film composition may comprise further additives including metals, metal oxides or any compounds that can generate these metals or metal oxides during firing. The components are discussed herein below.

All surface areas mentioned in this description refer to surface areas measured by BET according to DIN ISO 9277, 2003-05.

### Metal

The metal providing the electrical conductivity is preferably selected from the group consisting of Cu, Ag, Pd, Zn, Ni, Sn, Al, Bi, alloys of Cu, Ag, Zn, Ni, Sn, Al, Bi, Pd, In, Sb and mixtures thereof. The metal can be in a flake form, a spherical form, a granular form, a crystalline form, a powder, or other irregular forms and mixtures thereof. The electrically conductive metal can be provided in a colloidal suspension.

Preferably, the metal is selected from Ag, Cu, Zn, Sn. Especially preferred is Ag. It can be in the form of silver metal, silver derivatives, or mixtures thereof. Exemplary derivatives include: alloys of silver, silver oxide (Ag₂O), silver salts such as silver chloride (AgCl), silver nitrate (AgNO₃), silver acetate (AgOOCCH₃), silver trifluoroacetate (AgOOCF₃), silver orthophosphate (Ag₃PO₄), for example. Other forms of silver compatible with the other thick-film paste components can also be used.

In one embodiment, the metal or derivatives thereof is from about 60 to about 95 wt.% of the solid components of the thick-film composition. In a further embodiment, the electrically conductive metal or derivatives thereof is from about 75 to about 92 wt. % of the solid components of the thick-film composition.

Specific surface area and particle size are not subject to any particular limitation. Preferably, the specific surface area of the metal particles is equal to or more than 1.8 m²/g, preferably in the range of 2.0 to 17.0 m²/g. Preferably, the particle size (D50) of the metal is in the range from 0.05 to 10 µm, and preferably in the range from 0.2 to 6 µm.

Unless otherwise indicated herein, all particle sizes or average particle sizes stated herein are D50 particle diameters measured by laser diffraction. As well understood by those in the art, the D50 diameter represents the size at which half of the individual particles (by weight) are smaller than the specified diameter. Such diameters provide the metal with suitable sintering behavior and spreading of the thick film conductive composition on the antireflection layer when forming a solar cell.

### Glass Frit

The glass frit (glass particles) functions as an inorganic binder in the electroconductive paste composition and acts as a flux material to deposit the metal onto the substrate during firing. The specific type of glass is not critical provided that it comprises bismuth oxide. Preferably, the glass frit is a substantially lead-free glass frit or a glass-frit having a lead oxide content of less than 0.5 wt.% based on the total weight of the glass composition. Preferred is a glass frit free of lead.

The glass particles preferably have a particle diameters (D50) of about 0.1 to about 10 µm, more preferably less than about 5 µm, even more preferably less than 1 µm and are preferably contained in the composition in an amount of 0.1 to 10 wt.-%, more preferably from 0.2 wt.% to 5 wt.-% based on the total weight of the solid components of the thick-film composition.

The glass frit is a bismuth oxide comprising glass frit, preferably a glass frit having Bi₂O₃-content of 50 to 85 wt.-%, more preferably a Bi₂O₃-content of 55 to 85 wt.-% based on the total weight of the glass composition. Appropriate glasses are bismuth silicate, bismuth borosilicate or zinc borosilicate. Especially preferred are bismuth borosilicate glasses containing Bi₂O₃ as the major component. Typical glass frits further comprise 0.0 to 10 wt.% of Sb₂O₃, 0.0 to 10 wt.-% of SiO₂, 0.0 to 7 wt.-%, in particular 2 to 6.5 wt.% of Al₂O₃, 3 to 10 wt.-% of ZnO, 0.0 to 10.0 wt.% Li₂O, 0.0 to 8.0 wt.-% of P₂O₅, 0.0 to 10 wt.% of B₂O, 0.0 to 10 wt.-% In₂O₃, 2.0 to 15 wt.-% TeO and 0.0 to 10 wt.% of MgO, all based on the total weight of the glass composition, and have a softening temperature in the range from 280°C to 500°C, preferably 300 to 450°C. The thick-film composition may comprise one or more glass-frits, e.g. it may comprise two different glass frits.

According to one embodiment of the present invention the glass frit may also comprise antimony oxide in an amount from 0.1 to 10 wt.-%, based on the total weight of the glass composition.

The glass frits can be according to standard glass melting technology by mixing appropriate amounts of powders of the individual ingredients, heating the powder mixture in air or an oxygen-containing atmosphere to form a melt, quenching the melt, grinding and ball-milling the quenched material, and screening the milled material to provide a powder with the desired particle size. Firing the mixture of oxides is typically conducted to a peak temperature of 800 to 1200°C. The molten mixture can be quenched, for example, in distillated water to form a granulate. The resulting granulate can be milled to form a powder. Typically, the milled powder has a D50 of 0.1 to 5.0 µm.

### Additives

As additives additional metal or metal oxide may be present in the thick film composition of the present invention and may be selected from (a) a metal wherein said metal is selected from Zn, Ti, Sn, Ru, Co, In, Ag, Bi, Sb, and Mg (b) a metal oxide, wherein the metal is selected from Zn, Sn, Sb, Ru, and Co (c) any compounds that can generate the metal oxides of (b) upon firing, and (d) mixtures thereof. An especially preferred additive is zinc oxide or any compound that upon firing generate zinc oxide.

The particle size of the additional metal/metal oxide additives is not subject to any particular limitation, although an average particle size of no more than 10 µm, and preferably no more than 5 µm, is desirable.

The range of the metal/metal oxide additives including antimony oxide in the composition is typically 0.2 weight % to 5 weight % in the total composition.

It is also within the scope of the invention to include additional additives in the electroconductive paste composition. For example, it may be desirable to include thickener (tackifier), stabilizer, dispersant, viscosity adjuster, etc. compounds, alone or in combination. Such components are well known in the art. The amounts of such components, if included, may be determined by routine experimentation depending on the properties of the electroconductive paste that are desired.

### Antimony Oxide

The inventive thick film conductive composition comprises antimony oxide. The oxide may be any antimony oxide or any compound which upon firing converts into antimony oxide. Sb₂O₃ is preferred. Preferably, the amount of antimony oxide is in the range of 0.2 to 2 wt.%, preferably from 0.2 to 1.0 wt.% based on the total weight of the solid components of the thick-film composition. The particle size of the preferred Sb₂O₃ is preferably equal to or less than 1 µm.

The antimony oxide may either be added as an additive or it may be part of the glass frit or both. Antimony oxide added as an additive is preferred.

### Organic Medium

The particular organic medium, vehicle or binder is not critical and may be one known in the art. Use can be made of any of various organic vehicles, which may or may not contain thickeners, stabilizers and/or other common additives. The organic medium is typically a solution of polymer(s) in solvent(s). Additionally, a small amount of additives, such as surfactants, may be a part of the organic medium. The most frequently used polymer for this purpose is ethyl cellulose. Other examples of polymers include ethylhydroxyethyl cellulose, wood rosin, mixtures of ethyl cellulose and phenolic resins, polymethacrylates of lower alcohols, and monobutyl ether of ethylene glycol monoacetate can also be used. The most widely used solvents found in thick film compositions are ester alcohols and terpenes such as alpha- or beta-terpineol or mixtures thereof with other solvents such as kerosene, dibutylphthalate, butyl carbitol, butyl carbitol acetate, hexylene glycol and high boiling alcohols and alcohol esters. In addition, volatile liquids for promoting rapid hardening after application on the substrate can be included in the vehicle. Various combinations of these and other solvents are formulated to obtain the viscosity and volatility requirements desired.

The organic medium is preferably present in the composition in an amount of 5 to 25 wt.-%, more preferably from 8 - 15 wt.-% based on the total weight of the solid components of the thick-film composition.

The inorganic components are typically mixed with an organic medium by mechanical mixing to form viscous compositions called "pastes", having suitable consistency and rheology for printing. A wide variety of inert viscous materials can be used as organic medium. The organic medium must be one in which the inorganic components are dispersible with an adequate degree of stability. The rheological properties of the medium must be such that they lend good application properties to the composition, including: stable dispersion of solids, appropriate viscosity and thixotropy for screen printing, appropriate wettability of the substrate and the paste solids, a good drying rate, and good firing properties.

### Preparation of the thick-film composition

In one embodiment, the thick-film composition can be prepared by mixing the conductive metal powder, glass frit, optionally additives and the organic medium in any order. In some embodiments, the inorganic materials are mixed first, and they are then added to the organic medium. The viscosity can be adjusted, if needed, by the addition of solvents. Mixing methods that provide high shear may be useful.

According to the present invention is a process comprises:
i) providing a semiconductor substrate comprising one or more insulating films deposited onto at least one surface of the semiconductor substrate;
ii) applying a thick-film composition onto at least a portion of the one or more insulating films to form a layered structure, wherein the thick- film composition includes:
   a) metal or derivative thereof;
   b) a bismuth oxide comprising glass-frit;
   c) optionally additives; and
   d) an organic medium;
iii) firing the semiconductor substrate, one or more insulating films, and thick-film composition forming an electrode in contact with the one or more insulating layers and in electrical contact with the semiconductor substrate.

In one embodiment, a semiconductor device is manufactured from an article comprising a junction-bearing semiconductor substrate and a silicon nitride insulating film formed on a main surface thereof. The process includes the steps of applying (for example, coating or screen- printing) onto the insulating film, in a predetermined shape and thickness and at a predetermined position, the thick-film composition of the invention having the ability to penetrate the insulating layer, then firing so that thick-film composition reacts with the insulating film and penetrates the insulating film, thereby effecting electrical contact with the silicon substrate.

In detail the production of a solar cell having a dielectric layer on at least one surface of a semiconductor device comprises several steps.

In a first step of a process for forming the metallization of a front-side of a solar cell an antire-flective or dielectric layer is provided on a semiconductor device. Typically, the semiconductor device is a mono- or polycrystalline silicon wafer as is conventionally used for the production of silicon solar cells. It has a p-type region, an n-type region and a p-n junction.

The passivated or dielectric coating layer on the front side may be made, for example, of SiNₓ, SiOₓ, AlₓO_{y}, TiOₓ, HfOₓ, or combinations thereof, such as a dielectric stack of AlₓO_{y}/SiOₓ/SiNₓ, AlₓO_{y}/SiNₓ or, SiOₓ/SiNₓ, SiOₓ/SiOₓ. Deposition of the dielectric layer may be performed, for example, using a process such plasma CVD (chemical vapor deposition) in the presence of hydrogen or sputtering, ALD (atomic layer deposition), thermally grown (SiOₓ). The silicon oxide film is formed by thermal oxidation, sputtering, or thermal CFD or plasma CFD. The titanium oxide film can be formed by coating a titanium-containing organic liquid material onto the semiconductor substrate and firing, or by a thermal CVD. Typically the dielectric layers have a thickness in the range of atomic monolayer to 200 nm.

In a second step the front side electrode of the wafer made of the thick film conductive composition of the present invention is applied as so called fingers e.g. by screen printing on the antire-flective coating layer on the front side of the cell and subsequent drying. The front side bus bars are subsequently screen printed forming a so-called H pattern which comprises thin parallel finger lines (collector lines) and two or more busbars intersecting the finger lines at right angle. The busbars are featuring two or more continuous lines or separated pads overlapping and contacting the fingers.

In addition, commercially available aluminum paste and back-side silver paste are e.g. screenprinted onto the back-side of the substrate, and successively dried. It is possible to apply the aluminum paste first to the dielectric layer and later apply the thick film composition for forming the soldering pads or vice versa.

Other possible deposition processes are stencil print, extrusion, inkjet, laser transfer, flexprint.

In this the thick-film compositions are heated to remove the organic medium and sinter the metal powder. The heating can be carried out in air or an oxygen- containing atmosphere. This step is commonly referred to as "firing." The firing temperature profile is typically set so as to enable the burnout of organic binder materials from dried thick-film composition, as well as any other organic materials present. Firing is then typically carried out in a belt furnace with the wafer reaching a peak temperature in the range of 700 to 900°C for a period of 1 to 5 sec. The firing can be conducted at high transport rates, for example, 100- 500 cm/min, with resulting hold-up times of 0.05 to 5 minutes. Multiple temperature zones, for example 3-11 zones, can be used to control the desired thermal profile. The front electrode and the back electrodes can be fired sequentially or cofired.

On the front-side, the thick-film composition of the present invention sinters and penetrates through the insulating film during firing, and thereby achieves electrical contact with the emitter. This type of process is generally called "fire through." This fired-through state, i.e., the extent to which the paste melts and passes through the insulating film, depends on the quality and thickness of the insulating film, the composition of the paste, and on the firing conditions. Upon firing the busbars form an electrical contact to the fingers.

During the firing process aluminum diffuses from the aluminum paste into the silicon substrate on the backside, thereby forming a p+ layer, containing a high concentration of aluminum dopant. This layer is generally called the back surface field (BSF) layer, and helps to improve the energy conversion efficiency of the solar cell. The back-side silver paste may be fired at the same time. During firing, the boundary between the back-side aluminum and the back-side silver assumes the state of an alloy, thereby achieving electrical connection. Most areas of the back electrode are occupied by the aluminum electrode, owing in part to the need to form a p+ layer. At the same time, because soldering to an aluminum electrode is impossible, the silver or silver/aluminum back electrode is formed on limited areas of the backside as an electrode for interconnecting solar cells by means of copper ribbon or the like.

Local contacts between silicon wafer and aluminum paste may be also provided by laser fired contacts (LFC) after firing the aluminum paste.

The wafer is fired at a temperature above the melting point of aluminum to form an aluminum-silicon melt at the local contacts between the aluminum and the silicon, i.e. at those parts of the silicon wafer's back-surface not covered by the dielectric passivation layer.

In this process, the semiconductor substrate can be a single-crystal or multi-crystalline silicon electrode.

Articles comprising the semiconductor substrates may be useful in the manufacture of photovoltaic devices.

### Examples

Illustrative preparations and evaluations of thick-film compositions are described below.

### Example 1

The glass frits described herein are produced by a conventional glass making technique. Ingredients are weighed then mixed in the desired proportions as indicated in Table I and heated in a furnace to form a melt in ceramic crucibles. As well known in the art, heating is conducted to a peak temperature 800-1200°C and for a time such that the melt becomes entirely liquid and homogeneous. The molten glass is then quenched under distillated water. The resulting glass was then milled to form a powder with its 50% volume distribution set to a desired target of 1 to 5 µm. The glass frits have a BET according to ISO 9277 of 1.0 to 2.5 m²/g. One skilled in the art of producing glass frit may employ alternative synthesis techniques such as but not limited to water quenching, sol-gel, spray pyrolysis, or others appropriate for making powder forms of glass.

Specimens of the glass frits having low softening points of 300 to 600°C are shown in Table 1.

**Table 1**

| Glass composition % by weight | | | | | | | | | | | |
|---|---|---|---|---|---|---|---|---|---|---|---|
| Glass No.: | Bi₂O₃ | SiO₂ | Al₂O₃ | ZnO | Li₂O | P₂O₅ | B₂O₃ | MgO | TiO₂ | ZrO₂ | BaO |
| Glass A | 75,00 | 5,00 | 4,00 | 9,00 | | | 5,80 | 1,00 | | | |
| Glass B | 58,50 | 7,00 | 6,50 | 5,00 | 3,00 | 6,00 | 6,00 | 8,00 | | | |
| Glass C | 58,50 | 5,00 | 6,50 | 5,00 | 3,00 | 6,00 | 6,00 | | 2,00 | | 8,00 |
| Glass D | 81,00 | 3,00 | 1,00 | 5,00 | | 6,00 | 4,00 | | | | |
| Glass E | 81,00 | 9,50 | 2,00 | | | 6,00 | | | | 1,50 | |
| Glass F | 83,00 | 0,50 | 1,50 | 7,00 | 1,00 | | 7,00 | | | | |
| Glass G | 80,30 | | | | 9,60 | | 10,10 | | | | |

### Example 2

Thick film compositions were prepared according to standard procedures. To an organic vehicle (terpineol solution containing ethyl cellulose) the Ag powder, two different glass frits, and metal oxides as indicated in the Tables were added, resulting in a mixture of 84 wt.-% Ag powder, 3.5 wt.-% glass, 1.0 wt.-% oxides, and 11 wt.-% organic medium based on the total weight of the solid components of the thick-film composition. This mixture was premixed by a universal mixer and kneaded by a 3-roll mill, so that a silver conductive paste was obtained.

The silver-powder used in the examples and comparative examples had an average particle size D50 of 2.4 µm and a specific surface area measured by BET according to ISO 9277 of 2.3 m²/g.

Monocrystallline (cz) p-type silicon wafers of 156 mm² having a thickness of 180 µm were manufactured using screen printing processes. The silicon wafers comprised an n-type diffused POCl₃ emitter (70 Ω/square sheet resistance) and a 70 nm thick silicon nitride anti-reflection coating deposited by plasma-enhanced chemical vapor deposition (PE-CVD) on the front side. Onto the full area of the backside of the silicon wafer an aluminum paste (CypoSol S55-10, available by BASF AG, Ludwigshafen) was screen printed. The front side metallization was printed using different sample pastes according to the invention as indicated in Table 2 for printing H-grid screens with fingers and bus bars. Every H-grid comprises 75 fingers with finger opening of 80 µm and 3 bus bars of a width of 1.5 mm. The dried film thicknesses were in the range of 20-25 µm.

The coated silicon wafers were dried in a box furnace at 150°C for 10 min and fired in a continuous infrared firing furnace for completion of the metallization process. The spike profile with a throughput time of 1 min had a residence time of 3 s- 5 s at a temperature of more than 700°C.

The busbars of the fired samples were soldered to fluxed solder ribbon (ribbon: Sn62PB36Ag2, flux Kester Soldering Flux 961-E) with a soldering machine (Somont GmbH, Germany, 260°C soldering temperature, 1.5 s contact time, 175°C hot plate temperature). After soldering the bus bars were cut out with a diamond disc saw and glued onto alumina substrates using double-sided tape.

The solar cells were tested using an I-V tester (h.a.l.m. elektronik GmbH, Germany). The Xe arc lamp in the I-V tester irradiated the front surface of the solar cells using simulated sunlight with a known intensity to generate the I-V curve. Using this data, fill factor (FF), efficiency (Eff) and pseudo fill factor (pFF) were determined.

The mechanical adhesion of the ribbon soldered to the bus bars was tested with a GP Stable-Test Pro (GP Solar GmbH, Germany) under an angle of 45°.

For each sample the data of 5 solar cell samples were measured at settings of firing peak temperatures between 820°-880°C. The best results are presented in Table 2.

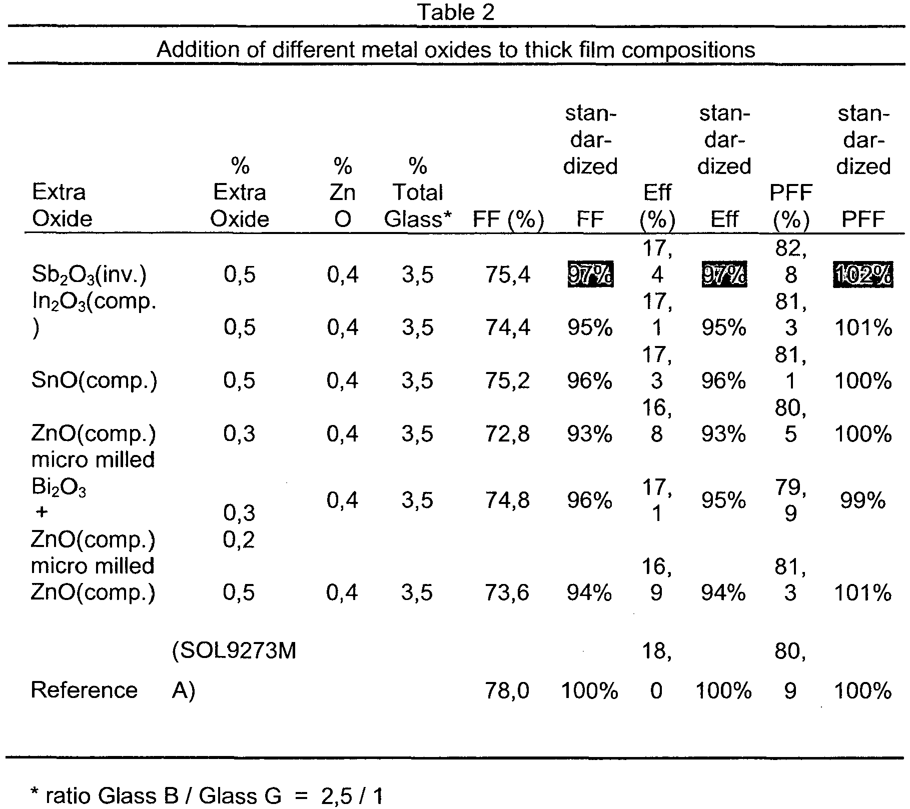

Table 2 shows the better performance of a solar cell using a lead-free font-side thick-film composition in comparison to solar cells using other lead-free thick film compositions. As a reference a solar cell with SOL9273MA is used. SOL9273MA is an actual high performance paste based on lead containing glass commercially available from Heraeus Precious Metal GmbH & Co. KG, Germany.

### Example 3

In the same manner as already described in Example 1 antimony oxide containing glasses having a BET between 1.0 and 2.5 m² were prepared. Glass compositions are shown in Table 3.

**Table 3**

| Sb₂O₃ glass composition of single glasses in wt.-% | | | | | | | | | |
|---|---|---|---|---|---|---|---|---|---|
| Glass No.: | Bi₂O₃ | Sb₂O₃ | TeO₂ | In₂O₃ | Li₂O | B₂O₃ | ZnO | MgO | ZrO₂ |
| Glass H | 69.00 | 5.00 | 5.00 | | 9.00 | | 9.00 | | 3.00 |
| Glass I | 80.00 | 8.00 | | 2.00 | 3.00 | 4,00 | 2.00 | | 1.00 |
| Glass K | 80.00 | 5.00 | | 5.00 | 2.00 | 6,00 | 2.00 | | |
| Glass L | 78.90 | 5.02 | | | 7.04 | 7,04 | | 2.00 | |

## Claims

1. A thick-film composition comprising:
a) a metal or derivative thereof;
b) a bismuth oxide containing glass frit;
c) optionally additives; and
d) an organic medium,
wherein the composition comprises antimony oxide

2. The thick-film composition according to claim 2,
further comprising zinc oxide.

3. The thick-film composition according to claim 1 or 2,
wherein the glass frit is substantially lead-free or the glass-frit has a lead oxide content of less than 0.5 wt.% based on the total weight of the glass composition.

4. The thick-film composition according to one of the preceding claims, comprising
60 to 95 % by weight of the metal and
0.2 to 2 % by weight of antimony oxide based on the total weight of the solid components of the thick-film composition.

5. The thick-film composition of claim 4, comprising
0.2 to 5 % by weight of metal additives and metal oxide additives including antimony oxide based on the total weight of the solid components of the thick-film composition.

6. The thick-film composition of one of the preceding claims, wherein the electrically conductive metal comprises silver.

7. The thick-film composition of one of the preceding claims, wherein the organic medium comprises a polymer.

8. The thick-film composition of claim 7, wherein the organic medium further comprises one or more further additives selected from the group consisting of solvents, stabilizers, surfactants, and thickeners.

9. The thick-film composition of one of the preceding claims, comprising one or more glass frits comprising 50 to 85 wt.-%, more preferably 55 to 85 wt.-% of Bi₂O₃, 0.0 to 10 wt.% of Sb₂O₃, 0.0 to 10 wt.-% of SiO₂, 0.0 to 7 wt.-%, in particular 2 to 6.5 wt.-% of Al₂O₃, 3 to 10 wt.-% of ZnO, 0.0 to 10.0 wt.% Li₂O, 0.0 to 8.0 wt.-% of P₂O₅, 0.0 to 10 wt.-% of B₂O, 0.0 to 10 wt.-% In₂O₃, 2.0 to 15 wt.-% TeO and 0.0 to 10 wt.-% of MgO, all weight percentages based on the total weight of the glass composition.

10. The thick-film composition of one of the preceding claims, comprising one or more additives selected from: (a) a metal wherein said metal is selected from Zn, Ti, Sn, Ru, Co, In, Ag, Bi, Sb, and Mg (b) a metal oxide, wherein the metal is selected from Zn, Sn, Sb, Ru, and Co, (c) any compounds that can generate the metal oxides of (b) upon firing, and (d) mixtures thereof.

11. A process comprising:
(i) providing a semiconductor substrate including one or more insulating films deposited thereon;
(ii) applying a thick-film composition according to one of claims 1 to 10 onto the one or more insulating films to form a layered structure, and
(iii) firing the semiconductor substrate, one or more insulating films, and thick-film composition, forming an electrode in contact with the one or more insulating layers and in electrical contact with the semiconductor substrate.

12. The process of claim 11, wherein the thick-film composition is applied pattern-wise onto the insulating film.

13. An article comprising:
a) a semiconductor substrate;
b) one or more insulating layers on the semiconductor substrate; and
c) an electrode in contact with the one or more insulating layers and in electrical contact with the semiconductor substrate, the electrode comprising bismuth oxide and antimony-oxide.

14. The article of claim 13, wherein the article is a solar cell.
